# EUROPEAN PATENT SPECIFICATION

(11) **EP 3 893 391 B1**
(45) Date of publication and mention of the grant of the patent: **22.07.2026**
(21) Application number: 20168408.1
(22) Date of filing: 07.04.2020
(51) Int. Cl.: H03F 3/08, H03F 3/70, H03F 1/26

(54) **AMPLIFIER CIRCUIT FOR A RADIATION DETECTOR**
VERSTÄRKERSCHALTUNG FÜR EINEN STRAHLUNGSDETEKTOR
CIRCUIT D'AMPLIFICATEUR POUR UN DÉTECTEUR DE RAYONNEMENT

(43) Date of publication of application: 13.10.2021
(73) Proprietor: Hitachi High-Tech Analytical Science Finland Oy, 02600 Espoo (FI)
(72) Inventor: Kairus, Jaakko, 09810 Nummi (FI); Kroneld, Mikael, 00100 Helsinki (FI)
(74) Representative: Papula Oy

(56) References cited:
- US-A1- 2003 063 427
- US-A1- 2009 134 949
- US-A1- 2018 006 613
- US-A1- 2018 035 061
- US-B1- 6 339 363
- US-B1- 6 642 496

## Description

### FIELD OF THE INVENTION

The invention relates to the technical field of hardware components used in the detection of electromagnetic radiation. In particular, the invention relates to the hardware used to convert a radiation-induced charge signal into a voltage signal.

### BACKGROUND OF THE INVENTION

Solid-state semiconductor radiation detectors utilize the tendency of incoming radiation photons to create free charge carriers in the semiconductor material. A bias voltage between electrodes in the radiation detector is used to gather the created charge carriers to the electrodes, creating what can be called a charge signal. The number of free charge carriers created by a photon is proportional to the initial energy of the photon, so in order to achieve good energy resolution it is important to be able to measure the magnitude of the charge signal as accurately as possible. In order to convert the charge signal into a voltage signal, the amplitude of which is indicative of the number of collected charge carriers, a charge sensitive preamplifier is used.

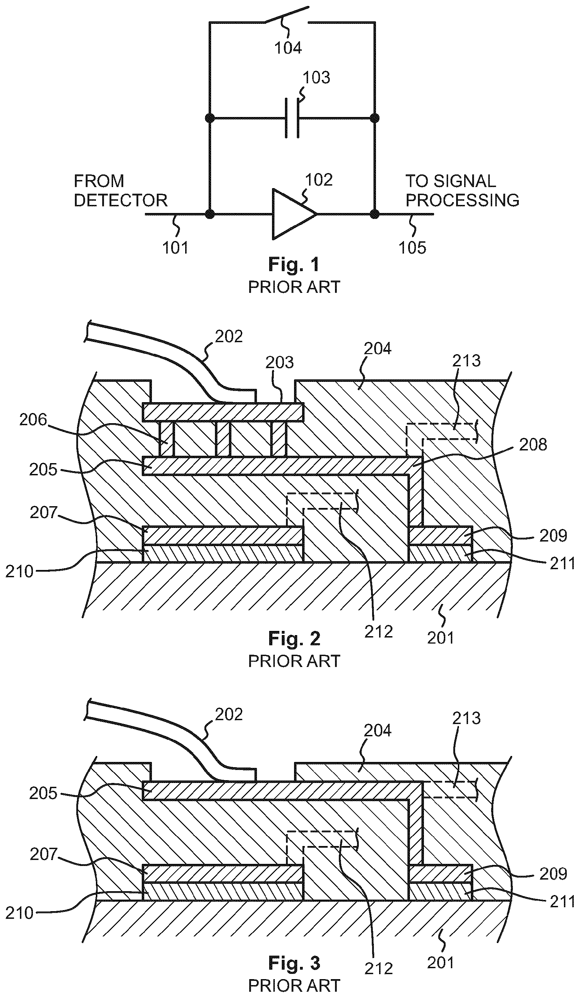

Fig. 1 illustrates a circuit diagram model of a preamplifier circuit used for the purpose described above. The SDD (Silicon Drift Detector) or other solid-state semiconductor radiation detector is connected to the input line 101 on the left. The input line 101 is coupled to the input of an amplifier 102, with a capacitor 103 coupled across its input and output. A reset switch 104 is coupled across the capacitor 103. The electric charge that the incoming radiation causes to accumulate in the detector essentially charges the capacitor 103, so that a voltage signal appears at the output 105 of the preamplifier circuit. The amplitude of the voltage signal is indicative of the amount of accumulated electric charge. The reset switch 104 is used to controllably discharge the capacitor 103 in accordance with the selected measuring strategy.

The signal to noise ratio that can be achieved with a preamplifier circuit like that in fig. 1 depends heavily on various hardware-dependent factors, like the stray capacitances that occur in various part of the circuit elements. Fig. 2 illustrates the cross section of a semiconductor chip structure proposed in a prior art document US 2018/0006613 A1, claiming to have minimal stray capacitances. The structure of fig. 2 is built on a substrate 201, such as a silicon or sapphire substrate. A bonding wire 202 connects the detector diode (not shown) to a bonding pad 203. Below the bonding pad 203, buried within insulating oxide material 204, is an upper conductive plate 205 that constitutes a first plate of the capacitor. Vertical vias 206 connect the bonding pad 203 to the upper conductive plate 205. Deeper towards the substrate 201 is a lower conductive plate 207 that constitutes a second plate of the capacitor.

A conductive connection 208 connects the upper conductive plate 205 to further hardware parts 209 on the same semiconductor chip, essentially to the gate electrode of a field-effect transistor that in the circuit diagram of fig. 1 is included in the amplifier 102. Insulator films 210 and 211 are provided between appropriate conductive parts and the substrate 201. Further conductive connections 212 and 213, which in fig. 2 do not appear in the cross section plane, connect the lower and upper plates 207 and 205 to a controllable switching component (not shown) that corresponds to the reset switch 104 in fig. 1. The conductive connection 212 from the lower conductive plate 207 also connects it to the output of the amplifier, as shown in fig. 1.

Fig. 3 illustrates a simplified version of the structure shown in fig. 2. Also the structure shown in fig. 3 is known from the same prior art document US 2018/0006613 A1. Basically just a separate bonding pad has been omitted, and an exposed portion of the upper plate 205 is used for bonding.

While the structures shown in figs. 2 and 3 are relatively effective in avoiding stray capacitances, they are somewhat inflexible with respect to the gain values that can be selected for the preamplifier circuit. Concerning the circuit diagram of fig. 1, the capacitance of the capacitor 103 is decisive for the amplifier gain. If its capacitance is small, amplifier gain is high and vice versa. High amplifier gain allows detecting very low energy radiation, but it also involves the risk of saturating the amplifier if the radiation energy is larger than expected. On the other hand, if the amplifier gain is modest the risk of saturating the amplifier is smaller, but detection sensitivity is not as good.

Prior art document US 6 339 363 B1 discloses various arrangements for measuring the charge stored on a source capacitor with an amplifier.

Another prior art document US 2018/035061 A1 discloses an imaging array, in which pixel sensors and readout circuits are fabricated on a substrate.

Another prior art document US 6 642 496 B1 discloses a radiation sensor in which each unit cell in an array of unit cells has a detector and a gain element.

Another prior art document US 2003/063427 A1 discloses a variable capacitor structure built in the layers of a multilayer circuit board.

Another prior art document US 2009/134949 A1 discloses an apparatus for matching impedances within an RF integrated circuit.

### SUMMARY

It is an objective to present an amplifier circuit for a radiation detector that could combine good detection sensitivity with low risk of amplifier saturation. Another objective is to present an amplifier circuit with wide dynamic range when used together with a radiation detector. A further objective is to ensure that the amplifier circuit can be manufactured with good repeatability and small variance in device characteristics between devices of a manufactured series. Yet another objective is to present an amplifier structure with low noise and small stray capacitances.

These and further advantageous objectives are achieved by providing at least one additional intermediate conductive layer below the bonding pad and using the conductive layers and associated switches to build a controllable capacitance.

According to a first aspect there is provided an amplifier circuit for a radiation detector. The amplifier circuit comprises an input node comprising a bonding pad, for receiving a charge signal from said radiation detector, and an amplifier with an input and an output. The input of said amplifier is coupled to said input node. An output node of the amplifier circuit is coupled to the output of said amplifier. A capacitive coupling is coupled between the input and output of said amplifier. A reset switch is coupled across said capacitive coupling. The capacitive coupling comprises at least two capacitors coupled in series and a shunt switch. Said shunt switch is coupled across a respective one of said at least two capacitors. The amplifier circuit comprises a substrate and, on top thereof, a stack of at least three conductive plates. A first conductive plate either constitutes the bonding pad or is conductively connected to said bonding pad and located between the bonding pad and the substrate. A second conductive plate is between said first conductive plate and said substrate. A third conductive plate is between said second conductive plate and said substrate. The at least three conductive plates are separated from each other by insulating layers. The at least three conductive plates are plates of said at least two capacitors. This involves the advantage that the structure can be realized with very small stray capacitances and other interfering factors.

According to an embodiment said capacitive coupling comprises a first capacitor coupled between the input of said amplifier and a common point and a second capacitor coupled between said common point and the output of said amplifier, so that said shunt switch is coupled across one of said first and second capacitors. This involves the advantage that the capacitive coupling can be advantageously realized with a stack of conductive layers in a semiconductor chip.

According to an embodiment said shunt switch is a first shunt switch coupled across said first capacitor, and the capacitive coupling comprises a second shunt switch coupled across said second capacitor, so that together the first and second shunt switches form said reset switch. This involves the advantage that the double use can be made of the switches.

According to an embodiment said capacitive coupling comprises a chain of N capacitors, where N is a positive integer larger than 2, coupled in series between the input and output of said amplifier. The capacitive coupling may then comprise M shunt switches, where M is a positive integer larger than 1 but smaller than N. Each of said M shunt switches may be coupled across at least one and at most M of said N capacitors. This involves the advantage that a large variation of different capacitance values can be obtained by selectively opening and closing the switches.

According to an embodiment the bonding pad and the first conductive plate may then be conductively connected tc each other. The arrangement may comprise conductive connections from said first conductive plate to the input of said amplifier and to a first pole of said reset switch. The arrangement may comprise a conductive connection from said second conductive plate to a first pole of said shunt switch. The arrangement may comprise conductive connections from said third conductive plate to a second pole of said reset switch, to a second pole of said shunt switch, and to the output of said amplifier. This involves the advantage that the structure can be easily manufactured in a semiconductor chip manufacturing process.

According to an embodiment said first, second and third conductive plates as well as said conductive connections are embedded in an insulator layer on top of said substrate. This involves the advantage that the structure is sturdy and reliable and can be packetized as a semiconductor chip.

According to an embodiment the first conductive plate constitutes the bonding pad. The arrangement may comprise conductive connections from said first conductive plate to the input of said amplifier and to a first pole of said reset switch. The arrangement may comprise a conductive connection from said second conductive plate to a first pole of said shunt switch. The arrangement may comprise conductive connections from said third conductive plate to a second pole of said reset switch, to a second pole of said shunt switch, and to the output of said amplifier. This involves the advantage that the structure can be made simpler, when no separate bonding pad is required.

According to an embodiment said second and third conductive plates as well as said conductive connections are embedded in an insulator layer on top of said substrate. This involves the advantage that the structure is sturdy and reliable and can be packetized as a semiconductor chip.

### BRIEF DESCRIPTION OF THE DRAWINGS

The accompanying drawings, which are included to provide a further understanding of the invention and constitute a part of this specification, illustrate embodiments of the invention and together with the description help to explain the principles of the invention. In the drawings:
**Figure 1** illustrates a known amplifier circuit,
**Figure 2** illustrates an implementation of the amplifier circuit of fig. 1,
**Figure 3** illustrates an alternative implementation of the amplifier circuit of fig. 1,
**Figure 4** illustrates an amplifier circuit according to an embodiment,
**Figure 5** illustrates a variation of the amplifier circuit of fig. 4,
**Figure 6** illustrates a variation of the amplifier circuit of fig. 4,
**Figure 7** illustrates an implementation of the amplifier circuit of fig. 4, 5, or 6,
**Figure 8** illustrates an amplifier circuit according to another embodiment,
**Figure 9** illustrates a variation of the amplifier circuit of fig. 8,
**Figure 10** illustrates an implementation of the amplifier circuit of fig. 8,
**Figure 11** illustrates an alternative implementation of an amplifier circuit according to fig. 4, 5, or 6,
**Figure 12** illustrates an implementation of an amplifier circuit according to an embodiment,
**Figure 13** illustrates an amplifier circuit according to an embodiment,
**Figure 14** illustrates an amplifier circuit according to an embodiment, and
**Figure 15** illustrates an implementation of an amplifier circuit according to fig. 14.

### DETAILED DESCRIPTION

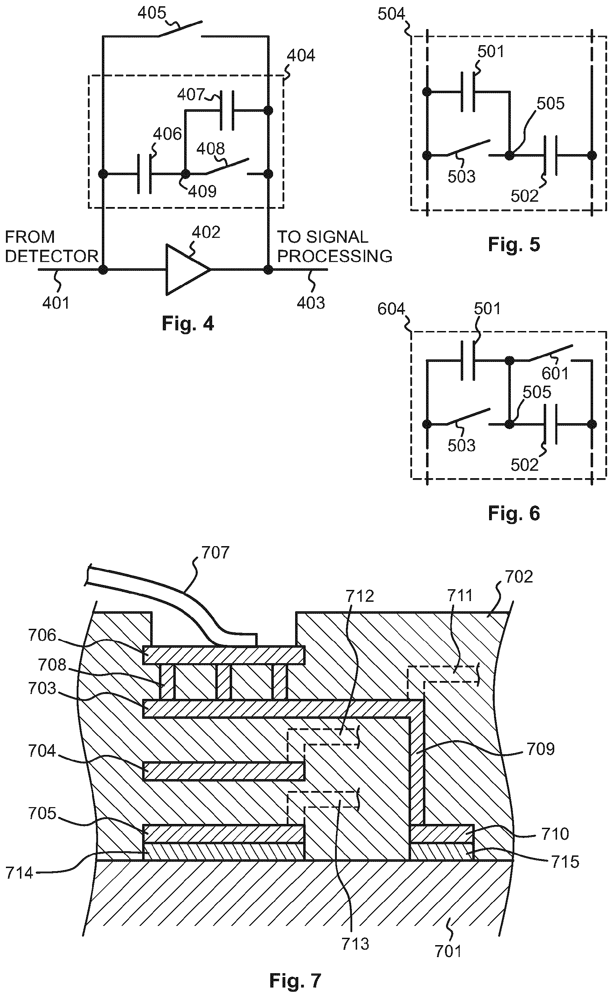

Fig. 4 illustrates an amplifier circuit for a radiation detector according to an advantageous embodiment. The radiation detector to be used is most advantageously a solid-state semiconductor radiation detector, in which an incoming photon creates a plurality of free charge carriers. The amplifier circuit comprises an input node 401 for receiving a charge signal from the radiation detector, as well as an amplifier 402. The input of the amplifier 402 is coupled to the input node 401, and the output of the amplifier 402 is coupled to an output node 403 of the amplifier circuit.

A capacitive coupling 404 is coupled between the input and output of the amplifier 402, external to the amplifier proper. A reset switch 405 is coupled across the capacitive coupling 404; in other words one pole of the reset switch 405 is coupled to an input node of the capacitive coupling 404 (and to the input of the amplifier 402), and another pole of the reset switch 405 is coupled to an output node of the capacitive coupling 404 (and to the output of the amplifier 402). The leftmost vertical conductor in fig. 4 can be considered as the input node of the capacitive coupling 404, and the rightmost vertical conductor in fig. 4 can be considered as its output node.

In contrast to the prior art circuit of fig. 1, the capacitive coupling 404 comprises more than just a single capacitor coupled between the input and output of the amplifier 402. The capacitive coupling 404 comprises two capacitors 406 and 407 coupled in series between the input and output nodes of the capacitive coupling. Additionally it comprises a shunt switch 408 coupled across one of the capacitors 406 and 407; here the shunt switch 408 is coupled across the second capacitor 407.

Fig. 5 illustrates an alternative capacitive coupling 504. In the embodiment of fig. 5 the capacitive coupling 504 comprises two capacitors 501 and 502 coupled in series between the input and output nodes of the capacitive coupling 504, just like in fig. 4. The difference in fig. 5 is that the shunt switch 503 is coupled across the first capacitor 501.

The embodiments of figs. 4 and 5 may be alternatively described so that in each of them the capacitive coupling 404 or 504 comprises a first capacitor (406 in fig. 4, 501 in fig. 5) coupled between the input of the amplifier 402 and a common point 409 or 505, and a second capacitor 407 or 502 coupled between the common point 409 or 505 and the output of the amplifier 402. The shunt switch 408 or 503 is coupled across one of the capacitors: across the first capacitor 501 as in fig. 5 or across the second capacitor 407 as in fig. 4.

It is commonly known that the inverse of the total capacitance of serially connected capacitors is the sum of the inverses of the individual capacitances. If, in any of the embodiments of figs. 4 or 5, the respective shunt switch 408 or 503 is non-conductive, the total capacitance of the capacitive coupling 404 or 504 can be calculated this way. If, on the other hand, the respective shunt switch 408 or 503 is conductive, the total capacitance of the capacitive coupling 404 or 504 is equal to the capacitance of the non-shunted capacitor 406 or 502. Thus, simply by opening or closing one switch, the capacitance of the capacitive coupling can be selected between a smaller value and a larger value. This in turn means that the gain of the amplifier circuit can be selected between a higher value and a lower value according to need.

Fig. 6 illustrates an alternative capacitive coupling 604. In the embodiment of fig. 6 the capacitive coupling 604 comprises two capacitors 501 and 502 coupled in series between the input and output nodes of the capacitive coupling 604, just like in figs. 4 and 5. The difference in fig. 6 is that in addition to the shunt switch 503 coupled across the first capacitor 501 there is another shunt switch 601 coupled across the second capacitor 502. This embodiment has the special feature that together the two shunt switches 503 and 601 form also the reset switch, which was shown as 405 in fig. 4. Making both shunt switches conductive at the same time discharges, i.e. resets, the series connection of the two capacitors 501 and 502 in fig. 6.

Fig. 7 is a cross section of an advantageous embodiment implementing a circuit of the kind shown in any of figs. 4 to 6 in the form of a semiconductor chip. In the following the structure shown in fig. 7 is first described as implementing the circuit of fig. 4.

In fig. 7 the amplifier circuit comprises a substrate 701, which may be any suitable substrate for semiconductor chips, such as a silicon or sapphire substrate for example. On top of the substrate 701 various conductive plates and connections are formed, at least partially embedded in an insulating layer 702 such as an oxide layer. Of particular interest here is the stack of three conductive plates 703, 704, and 705 on top of the substrate 701. They are separated from each other by insulating layers, which here are portions of the common insulating layer 702. This way the three conductive plates 703, 704 and 705 can be made to act as plates of the two capacitors 406 and 407 of fig. 4, or the two capacitors 501 and 502 of fig. 5 or fig. 6.

A first conductive plate 706, which can also be said to belong to said stack of (at least) three conductive plates 703, 704, and 705, constitutes a bonding pad in the embodiment of fig. 7. A bonding wire 707 is used to connect a radiation detector (not shown) to the bonding pad.

A second conductive plate 703 is located between the first conductive plate 706 and the substrate 701, and conductively connected to the first conductive plate 706. In this embodiment the conductive connection is made with conductive vertical vias, of which via 708 is shown as an example. A conductive connection 709 exists from the second conductive plate 703 to the input of the amplifier 402, represented in fig. 7 by a further conductive plate 710. It may be for example the gate of a field-effect transistor included in the amplifier 402. Another conductive connection 711 exists from the second conductive plate 703 to a first pole of the reset switch 405. The reset switch is not shown in fig. 7, but it may be similar to the reset switches used in prior art solutions such as those described earlier in relation to figs. 2 and 3. The other conductive connection 711 does not happen to lie within the plane of the cross section in fig. 7, for which reason it is shown with dashed lines.

A third conductive plate 704 is located between the second conductive plate 703 and the substrate 701. There is a conductive connection 712 from the third conductive plate 704 to a first pole of the shunt switch 408. The shunt switch is not shown in fig. 7, but it may be similar to for example the reset switches used in prior art solutions such as those described earlier in relation to figs. 2 and 3.

A fourth conductive plate 705 is located between the third conductive plate 704 and the substrate 701. There are conductive connections, commonly referred to as 713 in fig. 7, from the fourth conductive plate 705 to a second pole of the reset switch 405, to a second pole of the shunt switch 408, and to the output of the amplifier 402.

The implementation may comprise additional parts and layers, such as the additional insulator layers 714 and 715 shown in fig. 7.

With the conductive connections made as described above, the second conductive plate 703 and the third conductive plate 704 in fig. 7 constitute the plates of the first capacitor 406 of fig. 4. Similarly, the third conductive plate 704 and the fourth conductive plate 705 constitute the plates of the second capacitor 407 of fig. 4.

The comparison between figs. 4 and 7 above can be easily changed to one between figs. 5 and 7 or figs. 6 and 7 by making the appropriate changes regarding how the shunt switch (which is not shown in fig. 7 as such) is coupled with respect to the conductive connections 711, 712, and 713.

The arrangement of stacked conductor plates 703-706 involves similar advantages in reduced stray capacitances as the simpler structure of prior art shown in fig. 2. As a difference, the addition of an intermediate conductive layer and shunt switch offers the advantages of selectable amplifier circuit gain explained earlier with reference to figs. 4 to 6.

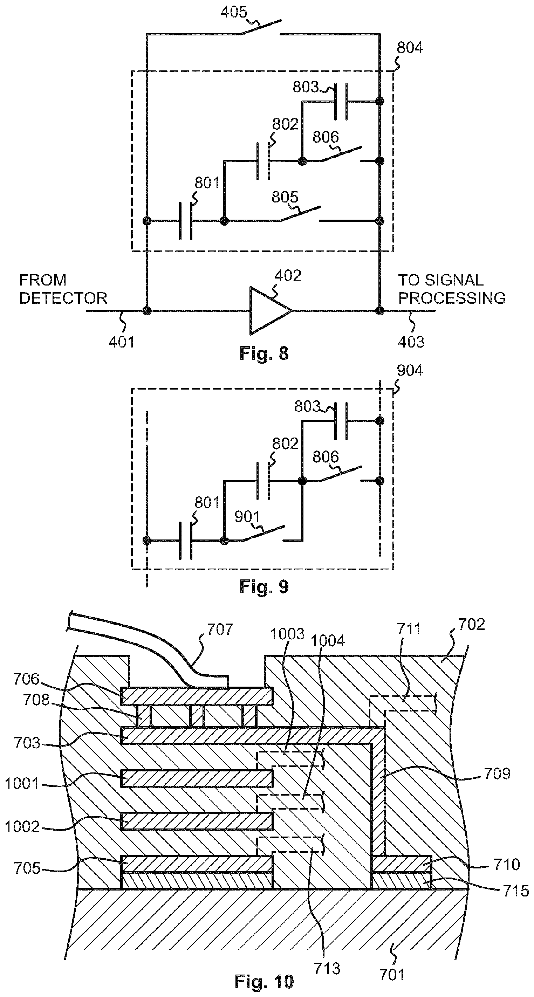

The capacitive coupling that enables selecting more than one capacitance value may comprise more capacitors than two, and/or more shunt switches than one. Fig. 8 illustrates an embodiment in which the capacitive coupling 804 comprises a chain of three capacitors 801, 802, and 803 coupled in series between the input and output of the amplifier 402. There are two shunt switches 805 and 806. Of these, the first shunt switch 805 is coupled across the chain of the second and third capacitors 802 and 803, and the second shunt switch 806 is coupled across the third capacitor 803. By selectively opening and closing the shunt switches 805 and 806, a total of three different capacitance values can be selected for the capacitive coupling 804, and consecutively for the gain of the amplifier circuit.

In the embodiment of fig. 9 the capacitive coupling 904 is otherwise the same as the capacitive coupling 804 of fig. 8, but the first shunt switch 901 is only coupled across the second capacitor 802. The embodiment of fig. 9 allows selecting a total of four different capacitance values by selectively opening and closing the shunt switches 806 and 901. Any of the embodiments of figs. 8 and 9 could be further modified by mirroring them with respect to the input and output nodes of the capacitive coupling 804 or 904, much like the capacitive coupling 504 of fig. 5 is a mirror image of that 404 in fig. 4.

The principle illustrated in figs. 8 and 9 can be generalized so that the capacitive coupling comprises a chain of N capacitors, where N is a positive integer larger than 2. They are coupled in series between the input and output of the amplifier 402. The capacitive coupling comprises M shunt switches, where M is a positive integer larger than 1 but smaller than N. Each of the M shunt switches is coupled across at least one and at most M of the N capacitors. Figs. 8 and 9 show examples of using the values N=3 and M=2.

Fig. 10 is a cross section of an advantageous embodiment implementing a circuit of the kind shown in any of figs. 8 or 9 in the form of a semiconductor chip. Parts that are similar to those in fig. 7 are shown with the same reference designators. A significant difference is the number of conductive plates in the stack above the substrate 701. From top to down, there are:
- the first conductive plate 706 that constitutes the bonding pad,
- the second conductive plate 703 from which there are the conductive connections 709 and 711 to the input of the amplifier 402 and to the first pole of the reset switch 405 respectively,
- a third conductive plate 1001,
- a fourth conductive plate 1002, and
- a fifth conductive plate 705, from which there are the conductive connections 713 to the second pole of the reset switch 405 as well as to the output of the amplifier 402.

Using the conductive connections 1003 and 1004 from the third and fourth conductive plates 1001 and 1002, as well as the appropriate switches, any of the embodiments of figs. 8 and 9 or their mirrored variants can be implemented.

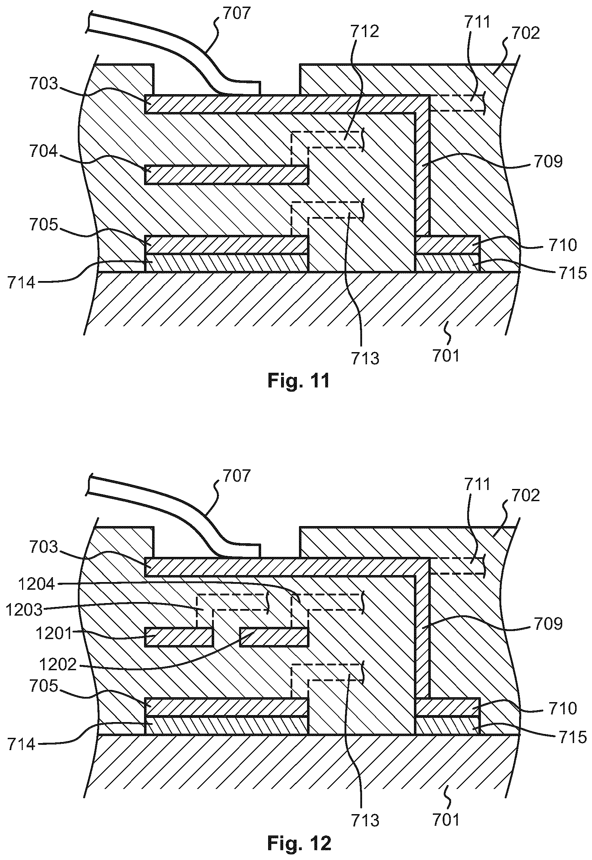

Fig. 11 is a cross section of an advantageous embodiment implementing a circuit of the kind shown in any of figs. 4 to 6 in the form of a semiconductor chip. Parts that are similar to those in fig. 7 are shown with the same reference designators. A significant difference is the absence of a dedicated conductive plate that would constitute a separate bonding pad. Instead, the upper, exposed surface of what was called the second conductive plate 703 above now constitutes the bonding pad to which the bonding wire 707 comes from the radiation detector (not shown).

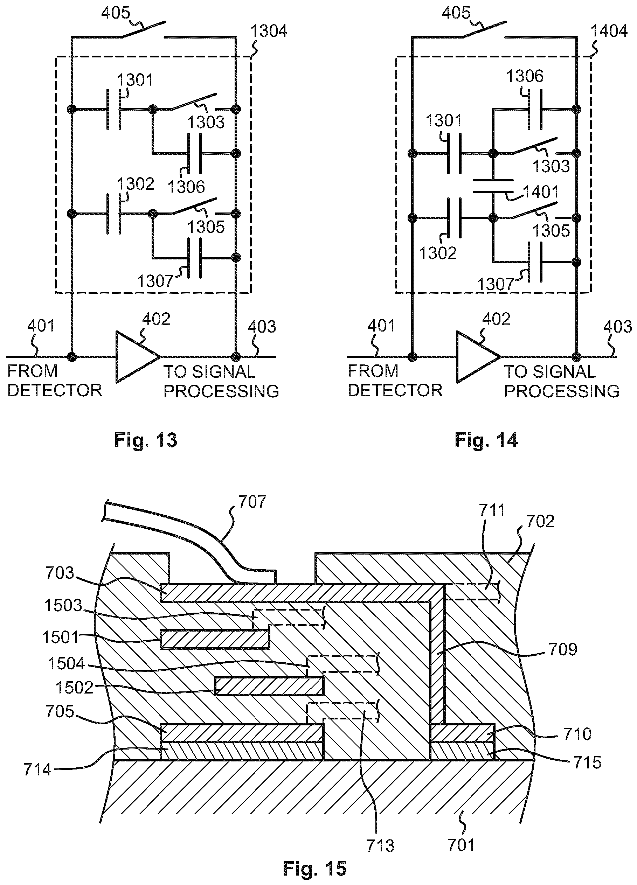

Fig. 12 is a cross section of an advantageous embodiment implementing a circuit of the kind shown in fig. 13. The embodiment shown in fig. 12 differs from that shown in fig. 11 in that the middle conductive plate, which is plate 704 in fig. 11, consists of two separate sub-plates 1201 and 1202 side by side, i.e. at the same height in the stack of conductive plates. Separate conductive connections 1203 and 1204 exist from each of these sub-plates to appropriate switches (not shown). Fig. 13 shows how the implementation of fig. 12 can be used to implement for example an amplifier circuit in which the capacitive coupling 1304 comprises two chains of a serially coupled capacitors 1301 and 1306, and 1302 and 1307, coupled in parallel. In the embodiment of fig. 13 the capacitive coupling comprises also two shunt switches 1303 and 1305, each of which is coupled across the second capacitor 1306 or 1307 of the respective capacitor chain.

Fig. 15 is a cross section of an advantageous embodiment implementing a circuit of the kind shown in fig. 14. The embodiment of fig. 15 differs from that shown in fig. 12 in that the sub-plates 1501 and 1502 are at different heights in the stack of conductive plates, and also partially overlap each other in a projection taken perpendicular to the surface of the substrate 701. Fig. 14 shows how the implementation of fig. 15 can be used to implement for example an amplifier circuit in which the capacitive coupling 1404 comprises a capacitor network, in which parallel capacitor chains like those in fig. 13 are partially capacitively cross-connected with at least one additional capacitor 1401. As such, there is some similar capacitive cross-coupling also in the embodiment of fig. 12, but it is more prominent in the embodiment of fig. 15 because of the partial overlap of the conductive plates.

Comparing figs. 7, 10, 11, 12, and 15 a general characterization of the semiconductor chip implementations described so far can be given as follows. The amplifier circuit comprises a substrate and on top of it a stack with at least three conductive plates separated from each other by insulating layers, so that said at least three conductive plates are plates of the at least two capacitors in the capacitive coupling between the input and output of the amplifier.

The principles of constructing the capacitive coupling that have been described above with reference to figs. 4, 5, 6, 8, 9, 13, and 14 can be combined with each other in many ways. For example, the use of a chain of shunt switches also as a reset switch, shown in fig. 6, can be applied also in the other couplings and not only those of figs. 4 or 5. Also using a dedicated conductive plate as a bonding pad, like in figs. 7 and 10, or making one of the other conductive plates double as a bonding pad like in figs. 11, 12, and 15, is not limited to just those embodiments in which they were described above. Both of these approaches can be freely combined with any other structural features of the stack of conductive plates, for example.

Concerning all embodiments described here and in the drawings it should be noted that the relative dimensions of the various parts are selected for illustrative purposes and graphical clarity only.

For manufacturing any of the implementations shown above, any suitable manufacturing process of semiconductor chips can be used. The conductive parts are typically made of metal such as aluminium, silver, gold, or the like. Also heavily doped semiconductor portions can be used as conductive parts.

It is obvious to a person skilled in the art that with the advancement of technology, the basic idea of the invention may be implemented in various ways. The invention and its embodiments are thus not limited to the examples described above, instead they may vary within the scope of the claims.

## Claims

1. Amplifier circuit for a radiation detector, comprising:
- an input node (401) comprising a bonding pad (706), for receiving a charge signal from said radiation detector,
- an amplifier (402) with an input and an output, the input of said amplifier (402) being coupled to said input node (401),
- an output node (403) coupled to the output of said amplifier (402),
- a capacitive coupling (404, 504, 604, 804, 904, 1304, 1404) coupled between the input and output of said amplifier (402),
- a reset switch (405) coupled across said capacitive coupling (404, 504, 604, 804, 904, 1304, 1404), wherein said capacitive coupling (404, 504, 604, 804, 904, 1304, 1404) comprises at least two capacitors (406, 407, 501, 502, 801, 802, 803, 1301, 1302, 1306, 1307, 1401) coupled in series and a shunt switch (408, 503, 601, 805, 806, 901, 1303, 1305), wherein said shunt switch (408, 503, 601, 805, 806, 901, 1303, 1305) is coupled across a respective one of said at least two capacitors (406, 407, 501, 502, 801, 802, 803, 1301, 1302, 1306, 1307, 1401)
- a substrate (701), and
- on top of said substrate (701) a stack of at least three conductive plates comprising:
-- a first conductive plate (703), which either constitutes the bonding pad or which is conductively connected to said bonding pad (706) and located between the bonding pad and the substrate,
-- a second conductive plate (704) between said first conductive plate (703) and said substrate (701), and
-- a third conductive plate (705) between said second conductive plate (704) and said substrate (701);
wherein the at least three conductive plates are separated from each other by insulating layers;
and wherein said at least three conductive plates (703, 704, 705, 1001, 1002, 1201, 1202, 1501, 1502) are plates of said at least two capacitors.

2. An amplifier circuit according to claim 1, wherein said capacitive coupling (404, 504, 604) comprises a first capacitor (406, 501) coupled between the input of said amplifier (402) and a common point (409, 505) and a second capacitor (407, 502) coupled between said common point (409, 505) and the output of said amplifier (402), so that said shunt switch (408, 503, 601) is coupled across one of said first (406, 501) and second (407, 502) capacitors.

3. An amplifier circuit according to claim 2, wherein:
- said shunt switch (503) is a first shunt switch coupled across said first capacitor (501), and
- the capacitive coupling (604) comprises a second shunt switch (601) coupled across said second capacitor (502);
so that together the first (503) and second (601) shunt switches form said reset switch (405).

4. An amplifier circuit according to claim 1, wherein said capacitive coupling (804, 904) comprises:
- a chain of N capacitors (801, 802, 803), where N is a positive integer larger than 2, coupled in series between the input and output of said amplifier (402), and
- M shunt switches (805, 806, 901), where M is a positive integer larger than 1 but smaller than N;
wherein each of said M shunt switches (805, 806, 901) is coupled across at least one and at most M of said N capacitors (801, 802, 803).

5. An amplifier circuit according to claim 1, wherein:
- the bonding pad (706) and the first (703) conductive plate are conductively connected to each other,
- conductive connections (709, 711) exist in the stack from said first conductive plate (703) to the input of said amplifier (402) and to a first pole of said reset switch (405),
- a conductive connection (712) exists in the stack from said second conductive plate (704) to a first pole of said shunt switch (408), and
- conductive connections (713) exist in the stack from said third conductive plate (705) to a second pole of said reset switch (405), to a second pole of said shunt switch (408), and to the output of said amplifier (402).

6. An amplifier circuit according to claim 5, wherein said first (703), second (704), and third (705) conductive plates as well as said conductive connections (709, 711, 712, 713) are embedded in an insulator layer (702) on top of said substrate (701).

7. An amplifier circuit according to claim 1, wherein:
- the first conductive plate constitutes the bonding pad,
- conductive connections exist in the stack from said first conductive plate to the input of said amplifier and to a first pole of said reset switch,
- a conductive connection exists in the stack from said second conductive plate to a first pole of said shunt switch, and
- conductive connections exist in the stack from said third conductive plate to a second pole of said reset switch, to a second pole of said shunt switch, and to the output of said amplifier.

8. An amplifier circuit according to claim 7, wherein said second and third conductive plates as well as said conductive connections are embedded in an insulator layer on top of said substrate.

## Patentansprüche

1. Verstärkerschaltung für einen Strahlungsdetektor, umfassend:
- einen Eingangsknoten (401) mit einem Bonding-Pad (706) zum Empfangen eines Ladungssignals von dem Strahlungsdetektor,
- einen Verstärker (402) mit einem Eingang und einem Ausgang, wobei der Eingang des Verstärkers (402) mit dem Eingangsknoten (401) gekoppelt ist,
- einen Ausgangsknoten (403), der mit dem Ausgang des Verstärkers (402) gekoppelt ist,
- eine kapazitive Kopplung (404, 504, 604, 804, 904, 1304, 1404), die zwischen den Eingang und den Ausgang des Verstärkers (402) geschaltet ist,
- einen Rücksetzschalter (405), der über die kapazitive Kopplung (404, 504, 604, 804, 904, 1304, 1404) geschaltet ist,
wobei die kapazitive Kopplung (404, 504, 604, 804, 904, 1304, 1404) mindestens zwei Kondensatoren (406, 407, 501, 502, 801, 802, 803, 1301, 1302, 1306, 1307, 1401), die in Reihe geschaltet sind, sowie einen Nebenschlussschalter bzw. ein Umschaltrelais (408, 503, 601, 805, 806, 901, 1303, 1305), wobei das Umschaltrelais (408, 503, 601, 805, 806, 901, 1303, 1305) über jeweils einen der mindestens zwei Kondensatoren (406, 407, 501, 502, 801, 802, 803, 1301, 1302, 1306, 1307, 1401) gekoppelt bzw. geschaltet ist
- ein Substrat (701) und
- auf dem Substrat (701) einen Stapel aus mindestens drei leitfähigen Platten, umfassend:
-- eine erste leitfähige Platte (703), die entweder das Bonding-Pad bildet oder die mit dem Bonding-pad (706) leitend verbunden ist und sich zwischen dem Bonding-Pad und dem Substrat befindet,
-- eine zweite leitfähige Platte (704) zwischen der ersten leitfähigen Platte (703) und dem Substrat (701) und
-- eine dritte leitfähige Platte (705) zwischen der zweiten leitfähigen Platte (704) und dem Substrat (701);
wobei die mindestens drei leitfähigen Platten durch Isolierschichten voneinander getrennt sind;
und wobei die mindestens drei leitfähigen Platten (703, 704, 705, 1001, 1002, 1201, 1202, 1501, 1502) Platten der mindestens zwei Kondensatoren sind.

2. Verstärkerschaltung gemäß Anspruch 1, wobei die kapazitive Kopplung (404, 504, 604) einen ersten Kondensator (406, 501), der zwischen den Eingang des Verstärkers (402) und einen gemeinsamen Punkt (409, 505) geschaltet ist, und einen zweiten Kondensator (407, 502) umfasst, der zwischen den gemeinsamen Punkt (409, 505) und den Ausgang des Verstärkers (402) geschaltet ist, sodass der Nebenschlussschalter (408, 503, 601) über einen der ersten (406, 501) und zweiten (407, 502) Kondensatoren geschaltet ist.

3. Verstärkerschaltung gemäß Anspruch 2, wobei:
- der Nebenschlussschalter (503) ein erster Nebenschlussschalter ist, der über den ersten Kondensator (501) geschaltet ist, und
- die kapazitive Kopplung (604) einen zweiten Shunt-Schalter (601) umfasst, der über den zweiten Kondensator (502) geschaltet ist;
sodass der erste (503) und der zweite (601) Nebenschlussschalter zusammen den Rücksetzschalter (405) bilden.

4. Verstärkerschaltung gemäß Anspruch 1, wobei die kapazitive Kopplung (804, 904) umfasst:
- eine Kette aus N Kondensatoren (801, 802, 803), wobei N eine positive ganze Zahl größer als 2 ist, die in Reihe zwischen dem Eingang und dem Ausgang des Verstärkers (402) geschaltet sind, und
- M Nebenschlussschalter (805, 806, 901), wobei M eine positive ganze Zahl größer als 1, aber kleiner als N ist;
wobei jeder der M Nebenschlussschalter (805, 806, 901) über mindestens einen und höchstens M der N Kondensatoren (801, 802, 803) geschaltet ist.

5. Verstärkerschaltung gemäß Anspruch 1, wobei:
- das Bondpad (706) und die erste (703) leitfähige Platte leitend miteinander verbunden sind,
- in dem Stapel leitende Verbindungen (709, 711) von der ersten leitenden Platte (703) zum Eingang des Verstärkers (402) und zu einem ersten Pol des Rücksetzschalters (405) vorhanden sind,
- in dem Stapel eine leitende Verbindung (712) von der zweiten leitenden Platte (704) zu einem ersten Pol des Shunt-Schalters (408) vorhanden ist,
und
- in dem Stapel leitende Verbindungen (713) von der dritten leitenden Platte (705) zu einem zweiten Pol des Rücksetzschalters (405), zu einem zweiten Pol des Nebenschlussschalters (408) und zum Ausgang des Verstärkers (402) vorhanden sind.

6. Verstärkerschaltung gemäß Anspruch 5, wobei die erste (703), zweite (704) und dritte (705) leitfähige Platte sowie die leitfähigen Verbindungen (709, 711, 712, 713) in eine Isolierschicht (702) auf der Oberseite des Substrats (701) eingebettet sind.

7. Verstärkerschaltung gemäß Anspruch 1, wobei:
- die erste leitfähige Platte das Bondpad bildet,
- in dem Stapel leitende Verbindungen von der ersten leitenden Platte zum Eingang des Verstärkers und zu einem ersten Pol des Rücksetzschalters vorhanden sind,
- in dem Stapel eine leitende Verbindung von der zweiten leitenden Platte zu einem ersten Pol des Nebenschlussschalters vorhanden ist, und
- in dem Stapel leitende Verbindungen von der dritten leitenden Platte zu einem zweiten Pol des Rücksetzschalters, zu einem zweiten Pol des Nebenschlussschalters und zum Ausgang des Verstärkers vorhanden sind.

8. Verstärkerschaltung gemäß Anspruch 7, wobei die zweite und die dritte leitfähige Platte sowie die leitfähigen Verbindungen in eine Isolierschicht auf der Oberseite des Substrats eingebettet sind.

## Revendications

1. Circuit amplificateur pour un détecteur de rayonnement, comprenant :
- un nœud d'entrée (401) comprenant un plot de contact (706), pour recevoir un signal de charge en provenance dudit détecteur de rayonnement,
- un amplificateur (402) avec une entrée et une sortie, l'entrée dudit amplificateur (402) étant couplée audit nœud d'entrée (401),
- un nœud de sortie (403) couplé à la sortie dudit amplificateur (402),
- un couplage capacitif (404, 504, 604, 804, 904, 1304, 1404) couplé entre l'entrée et la sortie dudit amplificateur (402),
- un commutateur de réinitialisation (405) couplé par l'intermédiaire dudit couplage capacitif (404, 504, 604, 804, 904, 1304, 1404), dans lequel ledit couplage capacitif (404, 504, 604, 804, 904, 1304, 1404) comprend au moins deux condensateurs (406, 407, 501, 502, 801, 802, 803, 1301, 1302, 1306, 1307, 1401) couplés en série et un commutateur de dérivation (408, 503, 601, 805, 806, 901, 1303, 1305), dans lequel ledit commutateur de dérivation (408, 503, 601, 805, 806, 901, 1303, 1305) est couplé par l'intermédiaire d'un respectif parmi lesdits au moins deux condensateurs (406, 407, 501, 502, 801, 802, 803, 1301, 1302, 1306, 1307, 1401)
- un substrat (701), et
- au-dessus dudit substrat (701) un empilement d'au moins trois plaques conductrices comprenant :
-- une première plaque conductrice (703), qui soit constitue le plot de contact, soit est connectée de manière conductrice audit plot de contact (706) et est située entre le plot de contact et le substrat,
-- une deuxième plaque conductrice (704) entre ladite première plaque conductrice (703) et ledit substrat (701), et
-- une troisième plaque conductrice (705) entre ladite deuxième plaque conductrice (704) et ledit substrat (701) ;
dans lequel les au moins trois plaques conductrices sont séparées les unes des autres par des couches isolantes ;
et dans lequel lesdites au moins trois plaques conductrices (703, 704, 705, 1001, 1002, 1201, 1202, 1501, 1502) sont des plaques desdits au moins deux condensateurs.

2. Circuit amplificateur selon la revendication 1, dans lequel ledit couplage capacitif (404, 504, 604) comprend un premier condensateur (406, 501) couplé entre l'entrée dudit amplificateur (402) et un point commun (409, 505) et un second condensateur (407, 502) couplé entre ledit point commun (409, 505) et la sortie dudit amplificateur (402), de façon à ce que ledit commutateur de dérivation (408, 503, 601) soit couplé par l'intermédiaire d'un parmi lesdits premier (406, 501) et second (407, 502) condensateurs.

3. Circuit amplificateur selon la revendication 2, dans lequel :
- ledit commutateur de dérivation (503) est un premier commutateur de dérivation couplé par l'intermédiaire dudit premier condensateur (501), et
- le couplage capacitif (604) comprend un second commutateur de dérivation (601) couplé par l'intermédiaire dudit second condensateur (502) ;
de façon à ce que les premier (503) et second (601) commutateurs de dérivation forment ensemble ledit commutateur de réinitialisation (405).

4. Circuit amplificateur selon la revendication 1, dans lequel ledit couplage capacitif (804, 904) comprend :
- une chaîne de N condensateurs (801, 802, 803), où N est un nombre entier positif supérieur à 2, couplés en série entre l'entrée et la sortie dudit amplificateur (402), et
- M commutateurs de dérivation (805, 806, 901), où M est un nombre entier positif supérieur à 1 mais inférieur à N ;
dans lequel chacun desdits M commutateurs de dérivation (805, 806, 901) est couplé par l'intermédiaire d'au moins un et d'au maximum M parmi lesdits N condensateurs (801, 802, 803).

5. Circuit amplificateur selon la revendication 1, dans lequel :
- le plot de contact (706) et la première plaque conductrice (703) sont connectés de manière conductrice l'un à l'autre,
- des connexions conductrices (709, 711) existent dans l'empilement depuis ladite première plaque conductrice (703) jusqu'à l'entrée dudit amplificateur (402) et jusqu'à un premier pôle dudit commutateur de réinitialisation (405),
- une connexion conductrice (712) existe dans l'empilement depuis ladite deuxième plaque conductrice (704) jusqu'à un premier pôle dudit commutateur de dérivation (408), et
- des connexions conductrices (713) existent dans l'empilement depuis ladite troisième plaque conductrice (705) jusqu'à un second pôle dudit commutateur de réinitialisation (405), jusqu'à un second pôle dudit commutateur de dérivation (408), et jusqu'à la sortie dudit amplificateur (402).

6. Circuit amplificateur selon la revendication 5,
dans lequel lesdites première (703), deuxième (704) et troisième (705) plaques conductrices ainsi que lesdites connexions conductrices (709, 711, 712, 713) sont intégrées dans une couche isolatrice (702) au-dessus dudit substrat (701).

7. Circuit amplificateur selon la revendication 1, dans lequel :
- la première plaque conductrice constitue le plot de contact,
- des connexions conductrices existent dans l'empilement depuis ladite première plaque conductrice jusqu'à l'entrée dudit amplificateur et jusqu'à un premier pôle dudit commutateur de réinitialisation,
- une connexion conductrice existe dans l'empilement depuis ladite deuxième plaque conductrice jusqu'à un premier pôle dudit commutateur de dérivation, et
- des connexions conductrices existent dans l'empilement depuis ladite troisième plaque conductrice jusqu'à un second pôle dudit commutateur de réinitialisation, jusqu'à un second pôle dudit commutateur de dérivation, et jusqu'à la sortie dudit amplificateur.

8. Circuit amplificateur selon la revendication 7, dans lequel lesdites deuxième et troisième plaques conductrices ainsi que lesdites connexions conductrices sont intégrées dans une couche isolatrice au-dessus dudit substrat.
